# EUROPEAN PATENT SPECIFICATION

(11) **EP 0 545 007 B1**
(45) Date of publication and mention of the grant of the patent: **05.11.1997**
(21) Application number: 92115760.8
(22) Date of filing: 15.09.1992
(51) Int. Cl.: H01L 23/433, H01L 23/495

(54) **A semiconductor device structure having a heat-sink and a plastics body, and highly reliable means of electrical connection to the heat-sink**
Halbleiteranordnung mit Wärmesenke und Kunststoffkörper und hochzuverlässige Mittel zur elektrischen Verbindung mit der Wärmesenke
Structure pour dispositif semi-conducteur comprenant un dissipateur de chaleur et un corps en plastique, et moyens extrêmement fiables pour sa connexion électrique au dissipateur de chaleur

(30) Priority: 29.11.1991 IT MI913208
(43) Date of publication of application: 09.06.1993
(73) Proprietor: SGS-THOMSON MICROELECTRONICS s.r.l., 20041 Agrate Brianza (Milano) (IT)
(72) Inventor: Casati, Paolo, I-20099 Sesto San Giovanni (Milano) (IT); Corno, Marziano, I-20069 Vaprio d'Adda (Milano) (IT); Marchisi, Giuseppe, I-20138 Milano (IT)
(74) Representative: Maggioni, Claudio

(56) References cited:
- EP-A- 0 484 297
- EP-A- 0 497 744
- GB-A- 2 199 988
- US-A- 4 132 856
- US-A- 4 215 360

## Description

This invention relates to electronic semiconductor devices, and particularly to such a device structure which comprises a metal plate and a plastics body attached to the plate whence the device terminal rheophores (leads) are led out.

As is known, integrated circuits and other active electronic devices or components are formed on plates (chips) of a semiconductor material having a surface area on the order of a few square millimeters, and require for their connection to an external electric circuit special supporting, enclosing and electric interconnection structures. A typical structure suited for the purpose comprises basically a plastics body enclosing a chip which is connected, by thin wires soldered to metallized regions specially provided on its surface, to corresponding electric conductors or terminal rheophores led out of the plastics body. With power integrated circuits, that is devices designed to operate on high currents, and therefore, liable to become heated to a significant extent, such structures also comprise a small metal plate through which a chip mounted thereon can transfer the heat generated during its operation to the environment.

In manufacturing the last-mentioned structures, a chip is secured on the metal plate either by soldering with a low-melt alloy such as a lead-tin alloy, or by cementing with a suitable adhesive such as an epoxy adhesive; a set of metal strips, intended to become the terminal rheophores for the device, are then blanked off thin sheet metal but still left joined to one another by interconnecting sections, and mounted to the plate in an electrically insulated manner therefrom; thin wires, usually of gold, are soldered, on the one side, to the metallized regions of the chip using a low-melt alloy, and on the other side, welded to the ends of the metal strips using a so-called "thermosonic" process wherein heat and ultrasound are applied simultaneosly; thereafter, the assembly is placed into a specially provided mold, into which a plastics material such as a thermosetting epoxy resin is then introduced in a liquefied state; on curing the resin, a structure is obtained which comprises a solid plastics body encapsulating the above-described elements excepting for one face of the metal plate and part of the metal strips, i.e. of the device terminal rheophores, and their interconnecting sections; the latter are then removed as by blanking to yield the finished electronic product.

It is necessary in some cases that at least one of the metallized regions on the chip be connected electrically to the metal plate. According to a prior art technique, this connection is established by attaching a thin wire, usually made of gold, with one end to the metallized region of the chip, and with the other end, directly to the plate by ultrasonic thermal welding, on a location of its surface where the chip is mounted. This type of connection is not, however, so reliable as it should be; it has been found, in particular, that the wire tends to separate from the plate due to failure of the welded joint. A verified cause of this problem is that the plate surface may be contaminated by the chip attachment material, whether a soldering alloy or an adhesive, so that quality of the ultrasonic thermal weld becomes low and likely to fail under mechanical or electrical stresses, however slight.

To remove such causes for failure, it has been proposed of forming a groove around the plate area where the chip is to be affixed. The groove provides a barrier to running molten solder or liquefied adhesive across the plate, thereby lowering the risk of the surface being contaminated.

It is found that, despite this precautionary measure, the faulty pieces due to the connecting wire to the plate coming loose are still a large number.

The document US-A-4 132 856 discloses a process for forming a plastic encapsulated molded film carrier package. A die is mounted on a heat sink and external connections are made to the bond pads on the die. The qround connection is made by solderinq a strap from the die to a pedestal which is in turn directly attached to the heat sink. The document US-A-4 215 360 discloses a power semiconductor device package in which a die is mounted on a heat sink and wire bonds are formed between the bond pads of the die and the leads of the lead frame.

It is the object of this invention to provide a structure of an electronic semiconductor device of the kind defined at the outset which is free from the aforementioned drawback. This object is achieved by the structure defined and characterized as in the claims at the close of the present description.

The invention can be more clearly understood from the following detailed description of an embodiment thereof, to be read in conjunction with the accompanying drawing, in which:
Figure 1 is a perspective view of a structure according to the invention, with a part removed to show its interior;
Figure 2 is a plan view of the structure in Figure 1, as it appears before the molding step;
Figure 3 is a sectional view taken along line III-III in Figure 2; and
Figure 4 is a sectional view taken along line IV-IV in Figure 2.

With reference to the drawing, the structure of an electronic semiconductor device shown in the various Figures comprises a body of a plastics material, designated 10, a multiplicity of metal strips or terminal rheophores 11, a metal plate 12 serving support and heat sink functions, and a chip 13 of a semiconductor material having an integrated circuit formed thereon and being joined to the metal plate by means of a layer 14 of a soldering alloy. The terminal rheophores 11 are formed as usual by blanking off a single piece of sheet metal, and before being separated from one another after the molding process, preferably again by blanking, are held together by interconnecting sections 15 into a framework, generally designated 16, as shown in Figure 2, which represents the structure prior to being encapsulated in plastics.

The rheophore ends within the framework 16 are connected, in the known manner described hereinbefore, to the metallized regions 17 of the chip by means of thin gold wires 18.

According to the invention, the framework 16 has two opposite side strips, blanked off the same sheet metal piece, which form two rods 19 inside the plastics body. Such rods are extended, in the embodiment illustrated by the drawing, to the body outside with narrowing portions quite similar to the terminal rheophores 11. Each rod 19 has two holes 20 for mounting the framework 16 to the plate 12 with the aid of special studs 21 integral with the plate. These are made of an electrically conductive material and formed preferably by dishing the plate simultaneously with the blanking step whereby the plate itself is formed. After passing the studs 21 through the holes 20, the studs 21 are riveted to secure the rods 19 and the whole framework 16 in place.

Two metallized regions 22 of the chip 13, which correspond to the electric ground terminal of the integrated circuit, are connected, through respective thin golden wires 23, to the rods 19 in the intermediate areas between the supporting studs 21. Thus, these two areas 22 are connected electrically to the metal plate 12 by the golden wires 23, rods 19, and studs 21.

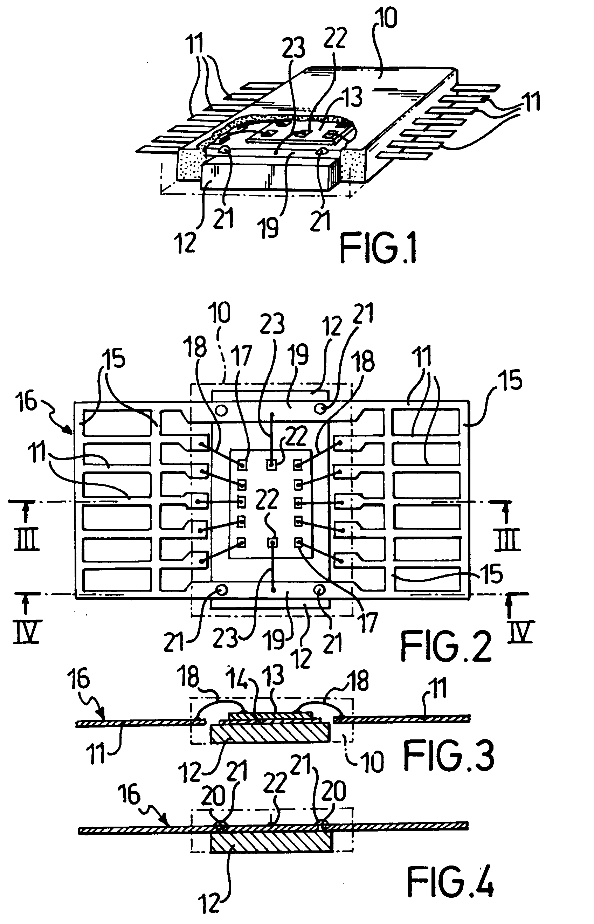

The formation of the plastics body 10 and blanking of the interconnecting sections 15 of the frame 16 are performed in the customary manner to provide the structure shown in Figure 1, which is closely similar in outward appearance to conventional integrated circuit supporting and enclosing structures.

Despite this resemblance in outward appearance, the structure of this invention has shown to be much more reliable than known structures as relates to the electric connection between the metallized regions forming the electric ground terminals and the sheet metal. The reason for this seems to be, in part, that any contaminations of the plate surface as due, for instance, to traces of the fastening material, i.e. solder or adhesive, incidentally dropped onto regions of the plate outside the area bordered by the containment groove, would not affect the ground wire weldment because the wire is welded to a different portion of the plate, and above all that lower mechanical wire stresses are applied to the weldment at the remote end from the chip. It would appear, in fact, that while the weldment on the rods has the same strength characteristics as a like weldment performed on the plate, the shear forces which develop between the metal and the plastics during the cooling stage following the molding step and during normal thermal cycles of operation, as due to the difference in the thermal expansion coefficients of the metal and the plastics, are far smaller in the structure of this invention. This effect is likely to originate from the rods being entrained by the plastics such that the welded joint will follow in part the shrinkages and expansions undergone by the plastics without opposing them.

Notice that the structure of this invention affords further non-negligible advantages, additionally to improved reliability as described above, such as a simplified manufacturing process, thanks to the possibility of eliminating the containment groove around the chip, because surface contamination by the material used for securing the chip is no longer a problem for the ground wire welding, and the facilitated assembly of the rheophore framework, since the latter can be secured at an exact and stable location on the plate by means of the holes and the studs.

While a single embodiment of the invention has been illustrated and described, several variants and modifications are feasible within the scope of this inventive concept. As an example, the rods could have no extensions outside the plastics body, i.e. could be fully encapsulated within the plastics body, or a single rod could be provided instead of two, or each rod could be connected to the plate by a single electrically conductive member, and in general, the latter may be implemented in other forms and constructions than the studs illustrated and described hereinabove.

## Claims

1. A semiconductor device structure comprising:
a metal plate (12) serving support and heat-sink functions;
a chip of a semiconductor material (13) attached to the plate (12) and having metallized regions (17,22) on its surface which form electrical terminals for the device;
terminal rheophores (11) for connection to an external electric circuit, each having one end adjacent to the semiconductor material chip (13);
interconnecting wires (18) between metallized regions (17) and said ends of the terminal rheophores (11);
means (19,21,23) of electrical connection between at least one metallized region (22) and the metal plate (12); and
a plastics body (10) encapsulating the metal plate (13) with the exception of at least some of its surface, the semiconductor material chip (13), the wires (18), and the ends of the terminal rheophores (11) adjacent to the semiconductor material chip (13);
characterized in that the electrical connection means (19,21,23) between at least one metallized region (22) of the chip (13) and the metal plate (12) comprise at least one metal rod (19) attached to the plate (12) with electrically conducti.ve means (21) and at least one wire (23) attached, at one end, to a metallized region (22) of the chip (13), and at the other end, to an area the metal rod (19) spaced apart from the attachment of the rod to the plate, said wire (23) and at least part of said rod (19) being encapsulated within the plastics body (10).

2. A semiconductor device structure according to Claim 1, characterized in that the rod (19) and terminal rheophores (11) are elongate flat members formed from a common sheet of metal.

3. A semiconductor device structure according to either Claim 1 or 2, characterized in that the electrically conductive means (21) for fastening the metal rod (19) to the plate (12) are at least one stud (21) formed integrally with the plate (12), passed through a corresponding hole (20) in the rod (19), and riveted.

4. A semiconductor device structure according to any of the preceding claims, characterized in that the rod (19) is extended, with at least one end thereof, to outside the plastics body (10).

5. A semiconductor device structure according to either Claim 3 or 4, comprising two metal rods (19) and characterized in that the two metal rods (19) lie parallel to each other close to one side of the semiconductor material chip (13), that they are each attached to the plate (12) by two studs (21) set a distance apart, and that the end of the wire (23) attached to each of the rods (19) locates intermediate to the points of attachment of the studs (21).

## Patentansprüche

1. Eine Halbleiterbauelementstruktur mit folgenden Merkmalen:
einer Metallplatte (12), die zu Träger- und Wärmesenken-Funktionen dient;
einem Chip aus einem Halbleitermaterial (13), der an der Platte (12) befestigt ist und metallisierte Regionen (17, 22) auf seiner Oberfläche aufweist, die elektrische Anschlüsse für das Bauelement bilden;
Anschlußleitungen (11) zur Verbindung mit einer externen elektrischen Schaltung, von denen jede ein Ende benachbart zu dem Halbleitermaterialchip (13) aufweist;
Verbindungsdrähten (18) zwischen metallisierten Regionen (17) und den Enden der Anschlußleitungen (11);
elektrischen Verbindungseinrichtungen (19, 21, 23) zwischen zumindest einer metallisierten Region (22) und der Metallplatte (12); und
einem Kunststoffkörper (10), der die Metallplatte (12) mit Ausnahme zumindest eines bestimmten Teils der Oberfläche derselben, den Halbleiternaterialchip (13), die Drähte (18) und die Enden der Anschlußleitungen (11) benachbart zu dem Halbleitermaterialchip (13), einkapselt;
dadurch gekennzeichnet, daß die elektrischen Verbindungseinrichtungen (19, 21, 23) zwischen zumindest einer metallisierten Region (22) des Chips (13) und der Metallplatte (12) zumindest einen Metallstab (19), der mittels einer elektrisch leitfähigen Einrichtung (21) an der Platte (12) befestigt ist, und zumindest einen Draht (23) aufweisen, der an einem Ende an einer metallisierten Region (22) des Chips (13) und an dem anderen Ende an einem Bereich des Metallstabs (19), der von der Befestigung des Stabs an der Platte beabstandet ist, befestigt ist, wobei der Draht (23) und zumindest ein Teil des Stabs (19) in den Kunststoffkörper (10) eingekapselt sind.

2. Eine Halbleiterbauelementstruktur gemäß Anspruch 1, dadurch gekennzeichnet, daß der Stab (19) und die Anschlußleitungen (11) längliche flache Bauglieder sind, die aus einem gemeinsamen Blech gebildet sind.

3. Eine Halbleiterbauelementstruktur gemäß Anspruch 1 oder 2, dadurch gekennzeichnet, daß die elektrisch leitfähige Einrichtung (21) zum Befestigen des Metallstabs (19) an der Platte (12) zumindest ein Bolzen (21) ist, der einstückig mit der Platte (12) gebildet ist, durch ein entsprechendes Loch (20) in dem Stab (19) verläuft und genietet ist.

4. Eine Halbleiterbauelementstruktur gemäß einem beliebigen der vorhergehenden Ansprüche, dadurch gekennzeichnet, daß der Stab (19) mit zumindest einem Ende desselben bezüglich des Kunststoffkörpers (10) nach außen verlängert ist.

5. Eine Halbleiterbauelementstruktur gemäß Anspruch 3 oder 4, die zwei Metallstäbe (19) aufweist und dadurch gekennzeichnet ist, daß die zwei Metallstäbe (19) parallel zueinander in der Nähe einer Seite des Halbleitermaterialchips (13) angeordnet sind, daß dieselben jeweils durch zwei Bolzen (21), die um einen Abstand beabstandet sind, an der Platte (12) befestigt sind, und daß das Ende des Drahts (23), der an jedem der Stäbe (19) befestigt ist, zwischen den Befestigungspunkten der Bolzen (21) angeordnet ist.

## Revendications

1. Structure pour dispositif semi-conducteur, comprenant:
une plaque métallique (12) servant à des fonctions de support et de dissipateur de chaleur;
une microplaquette faite dans un matériau semi-conducteur (13) attachée à la plaque (12) et ayant sur sa surface des régions métallisées (17, 22) qui forment des bornes électriques pour le dispositif;
des rhéophores de terminaison (11) en vue d'une connexion à un circuit électrique externe, ayant chacun une extrémité adjacente à la microplaquette de matériau semi-conducteur (13);
des fils d'interconnexion (18) entre les régions métallisées (17) et lesdites extrémités des rhéophores de terminaison (11);
des moyens (19, 21, 23) de connexion électrique entre au moins une région métallisée (22) et la plaque métallique (12); et
un corps en plastique (10) enrobant la plaque métallique (13) à l'exception d'au moins un peu de sa surface, la microplaquette de matériau semi-conducteur (13), les fils (18) et les extrémités des rhéophores de terminaison (11) adjacentes à la microplaquette de matériau semi-conducteur (13);
caractérisée en ce que les moyens de connexion électrique (19, 21, 23) entre au moins une région métallisée (22) de la microplaquette (13) et la plaque métallique (12) comprennent au moins une tige métallique (19) attachée à la plaque (12) à l'aide des moyens électriquement conducteurs (21) et au moins un fil (23) attaché, à une extrémité, à une région métallisée (22) de la microplaquette (13) et, à l'autre extrémité, à une aire de la tige métallique (19) à une certaine distance de l'attachement de la tige à la plaque, ledit fil (23) et au moins une partie de ladite t:ige (19) étant enrobés dans le corps en plastique (10).

2. Structure pour dispositif semi-conducteur selon la revendication 1, caractérisée en ce que la tige (19) et les rhéophores de terminaison (11) sont des membres plats allongés formés dans une feuille métallique commune.

3. Structure pour dispositif semi-conducteur selon la revendication 1 ou 2, caractérisée en ce que les moyens électriquement conducteurs (21) pour fixer la tige métallique (19) à la plaque (12) sont au moins un plot (21) faisant partie intégrante de la plaque (12), passé dans un trou correspondant (20) dans la tige (19), et riveté.

4. Structure pour dispositif semi-conducteur selon l'une quelconque des revendications précédentes, caractérisée en ce que la tige (19) s'étend, à au moins une de ses extrémités, hors du corps en plastique (10).

5. Structure pour dispositif semi-conducteur selon la revendication 3 ou 4, comprenant deux tiges métalliques (19) et caractérisée en ce que les deux tiges métalliques (19) sont parallèles entre elles tout près d'un côté de la microplaquette de matériau semi-conducteur (13), en ce qu'elles sont chacune attachées à la plaque (12) par deux plots (21) séparés entre eux, et en ce que l'extrémité du fil (23) attaché à chacune des tiges (19) est située entre les points d'attachement des plots (21).
